# EUROPEAN PATENT SPECIFICATION

(11) **EP 0 582 565 B1**
(45) Date of publication and mention of the grant of the patent: **03.07.1996**
(21) Application number: 91913713.3
(22) Date of filing: 03.05.1991
(51) Int. Cl.: H01B 12/02, H01L 39/24

(54) **SUPERCONDUCTOR AND PROCESS OF MANUFACTURE**
SUPRALEITER UND HERSTELLUNGSVERFAHREN
SUPRACONDUCTEUR ET PROCEDE DE FABRICATION

(43) Date of publication of application: 16.02.1994
(73) Proprietor: COMPOSITE MATERIALS TECHNOLOGY, Inc., Shrewsbury, MA 01545 (US)
(72) Inventor: WONG, James, Wayland, MA 01778 (US); RUDZIAK, Mark, M., Westminister, MA 01473 (US)
(74) Representative: Dubois-Chabert, Guy
(86) International application number: US9103078
(87) International publication number: WO9220076

(56) References cited:
- US-A- 3 534 459
- US-A- 3 625 662
- US-A- 3 652 967
- US-A- 4 803 310
- Proceedings of the 9th International Conference on Magnet Technology, MT-9, Swiss Institute of Nuclear Technology, Zuerich, 1985, G.L. DOROTEJEV, E. Yv. KLIMENKO, and S.V. FROLOV, "Current carrying Capacity of Superconductors with antificial Pinning", pages 564-566, (see introduction).

## Description

### BACKGROUND OF THE INVENTION

NbTi has long served as the backbone of the superconducting wire industry. Despite continued research into alternate materials, including the recent surge of interest in high-T_{c} superconductors, NbTi remains the superconductor of choice. Unfortunately, high quality NbTi wire is difficult to produce, requiring a complicated and time-consuming schedule of heat treatments. A composite material with the promise for rendering such heat treatment schedules unnecessary is desirable.

While a number of heat treatment schedules can be and are currently employed in the production of NbTi conductors, their purpose is the same: to precipitate α-Ti particles in the NbTi. These particles serve as defects capable of pinning flux lines. This pinning in turn allows high J_{c}'s to be achieved. The drawbacks to the heat treatment method of processing are numerous, but may be briefly summarized as follows:
1. The balance between the number and length of heat treatments, the pre-heat treatment strains andheat treatment temperatures is delicate. Hence, optimizing the J_{c} is difficult, and is vulnerable to errors during the processing of the wire.
2. The need for complicated heat treatment schedules lengthens processing time substantially and increases production costs.
3. The presence of α-Ti decreases the ductility of NbTi; this is manifested in difficulties in obtaining desired conductor piece lengths.
4. Extensive heat treatment introduces Ti-Cu compound formation problems that can only be avoided through the use of barrier materials.

It is well-known that α-Ti precipitates in NbTi greatly enhance J_{c} due to their ability to serve as flux pinning sites. These precipitates, which form at β-Nb-Ti grain boundaries, are generally created by a series of heat treatments separated by strain resulting from cold deformation. This strain encourages the α-Ti precipitation. A final, larger strain occurs after the last heat treatment. The final strain elongates the α-Ti and allows optimization of the J_{c}.

The particulars of the heat treatment schedule depend upon a number of factors: NbTi composition, homogeneity, etc. However, a typical schedule for the commonly used Nb46.5wt%Ti will involve three or more 300°C-450°C treatments, 40-80 hours in duration separated by areal reductions of approximately 1.6. The final areal reduction is usually in the range of 7-12.

The best of these schedules produces about 20 volume percent of α-Ti in the NbTi and J_{c}'s in excess of 3000 A/mm² at 5T and 4.2 K. In wires with these properties, the α-Ti is configured in a dense array of ribbons 10-20A° in thickness, 40-80A° apart, and with the aspect ratio dependent upon the final strain imparted (see, for example, P.J. Lee, J.C. McKinnell, and D.C. Larbalestier, "Restricted Novel Heat Treatments for Obtaining High J_{c} in Nb46.5wt%Ti", To be published, presented as paper #HX-03 at ICMC/CEC, Los Angeles, CA, July 25, 1989).

Clearly, the heat treatment method of producing pinning sites is not only time consuming but is also open to potentially disastrous errors. If heat treatment times or temperatures are incorrect, or if too much or too little strain is applied, initially good material can be rendered useless. A material that does not require such complicated processing and which reliably yields high J_{c}'s would thus be of tremendous value. Artificially pinned NbTi promises to be such a material.

Work performed several years ago by G.L. Dorofejev, E.Yu. Klimenko, and S.V. Frolov, ("Current-Carrying Capacity of Superconductors with Artificial Pinning Centers", Proceedings of the 9^{th} International Conference on Magnet Technology, MT-9, Swiss Institute of Nuclear Technology, P. 564-6, Zurich, 1985, ISPN 3-907998-00-6,) demonstrated for the first time that transition metals could be utilized as pinning sites in NbTi. These investigators produced wires containing a Nb50wt%Ti matrix surrounding up to 10⁷ microfilaments of Nb, Ti, or V. The microfilament spacings were equal to the microfilament diameters. These composites were processed without heat treatment to a variety of sizes for J_{c} testing. It was found that J_{c} increased in inverse proportion to the microfilament diameter down to 500A°. Below this size, mechanical and diffusional effects began to degrade the properties. The best of the composites, incorporating Nb filaments in the NbTi matrix, displayed a J_{c} of 3500 A/mm² at 5T and 4.2 K.

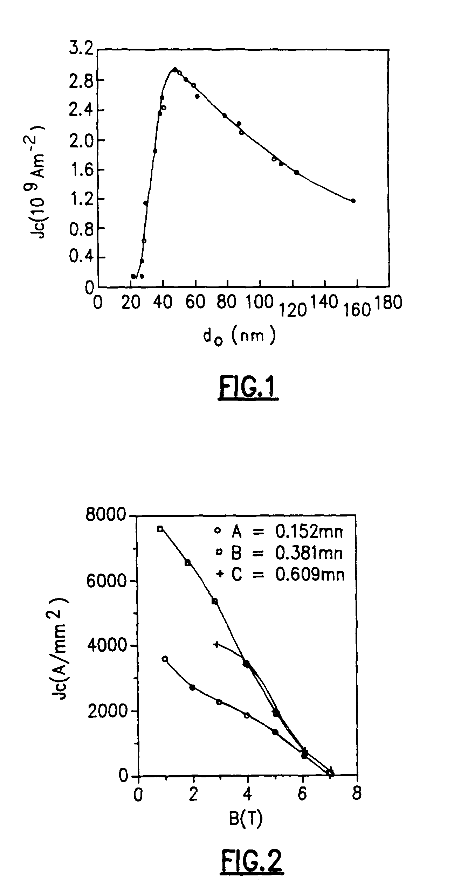

In work performed by I. Hlasnik et al., ("Properties of Superconducting NbTi Superfine Filament Composites with Diameters <0.1 µm", Cryogenics, vol. 25, October, 1985) Cu-NbTi composites consisting of 9,393,931 NbTi filaments embedded in Cu were fabricated via multiple restacks. No special heat treatments were employed during processing. NbTi filament diameters as low as 200A° were achieved, along with Cu matrix thicknesses of 100A°. Figure 1 shows a plot of critical current density versus filament diameter for a Cu-NbTi composite at 5T and 4.2 K. The peak J_{c} of approximately 3000 A/mm² occurs at 500A° filament diameter and is followed a rapid decline, consistent with the findings of Dorofejev et al.

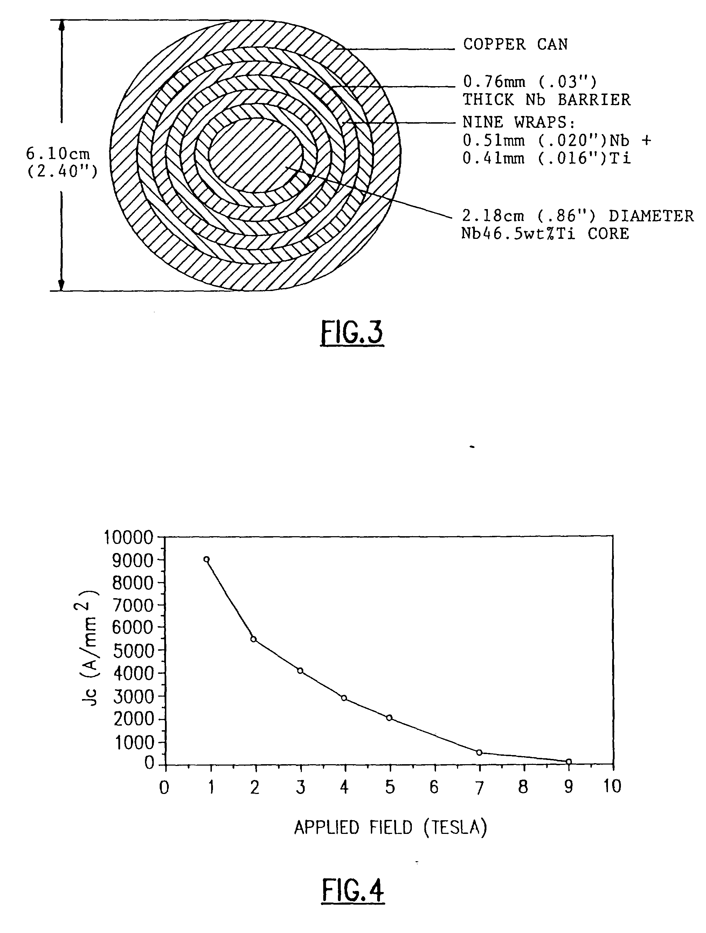

Recent work by L.R. Motowidlo, H.C. Kanithi, and B.A. Zeitlin, ("NbTi Superconductors with Artificial Pinning Structures", To be published, presented as paper #HX-01 at ICMC/CEC, Los Angeles, CA, July 25, 1989, see also U.S. Patent 4,803,310,) transposed the positions of the Nb and NbTi relative to the approach of Dorofejev et al., placing the NbTi within a Nb matrix. Employing multiple restacks, the investigators produced a multifilament wire containing 1250 filaments. Each of these copper clad filaments contained 5800 Nb46.5wt%Ti cores within a Nb matrix. The Nb and NbTi occupied equal volume fractions within the filaments. By simply drawing the multifilament material down, the investigators achieved J_{c}'s as high as 3700 A/mm² in a 0.51mm (.020") diameter wire at 4T and 4.2 K, corresponding to Nb and NbTi dimensions of about 150A° (matrix thickness) and 670A° (core diameter), respectively. A plot of J_{c} versus applied field for several of the wire diameters tested is shown in Figure 2. These data were taken at 4.2 K using a standard four point probe and helically wound samples. The voltage taps were separated by 75 cm.

The remarkably good low field behavior found by the investigators is mitigated by the poor high field behavior. H_{c}2 for the material was found to be only about 7.5T, well below that for conventionally processed material (11T). Nonetheless, the experiment clearly demonstrated transition metal pinning.

Older work by Roberts et al., U.S. Patent 3,625,662, December 7, 1971 and MacDonald, U.S. Patent 4,414,428, November 9, 1983, involved the fabrication of superconductors using layered sheet materials, but in neither case did the investigators contemplate the engineering of pinning mechanisms via the manipulation of superconducting and normal metals.

### BRIEF DESCRIPTION OF THE INVENTION

The essential elements of the invention comprise the following steps:
1. Creating a composite characterized by a periodic arrangement of at least two different "normal" transition metals so as to provide numerous interfaces between different "normal" transition metals. By "normal" transition metal is meant the transition metals Nb, Ti, Ta,Hf, Zr, and V.
2. Reaction of the transition metals to form a ductile superconducting alloy at the interfaces of these materials.
3. Limiting the extent of the reaction so as to maintain areas of pure or nearly pure transition metal along with the alloy.
4. Reduction of the composite such that the superconducting and normal metal thicknesses are less than 0.1 um, where the flux pinning at the superconducting-to-normal interfaces becomes most pronounced.

As a result of the above processing steps, there is created a product whose interfacial area between the two different normal transition metals has been enormously increased and this area has been created under conditions which convert the interface into a diffusion alloy of the two "normal" transition metals, which alloy is superconducting at high magnetic fields.

In one preferred form of the present invention, a superconductor is produced by the steps of wrapping a plurality of layers of metal sheets around a support to form a composite structure. The sheets are preferably pure transition metals - niobium, titanium, zirconium, or vanadium, for example - alternate sheets being formed of different transition metals. The support may be composed of any ductile metal. The resulting composite structure is mechanically reduced sufficiently so that each transition metal sheet is less than 1000A° thick. In the course of reduction, the composite is subjected to sufficient temperatures for sufficient times such that the transition metal layers are partially reacted to form a ductile superconducting material between the transition metal layers. Approximately one half by volume of the transition metal layers remain unreacted. These unreacted layers afford efficient flux pinning within the composite when the layers are reduced to the <1000A° final size.

The reaction of the transition metal layers should occur when said layers are greater than or equal to 1 µm in thickness and can be brought about by any means appropriate, including but not limited to, hot isostatic pressing, hot extrusion, or heat treatment. By reacting the layers at a relatively large thickness, the reaction can be controlled so that the desired superconducting and normal layer dimensions can be obtained. By contrast, heat treatments applied at final size, when the layers are extremely thin, could not be controlled to the extent necessary to maintain unreacted material. That unreacted layers must be maintained distinguishes this invention from that of Roberts et al., where no such provision is made.

### DETAILED DESCRIPTION OF THE INVENTION

In order to more fully understand the invention, reference should be had to the following detailed description taken in conjunction with the attached drawings, wherein:
Figure 1 is from I. Hlasnik et al., "Properties of Superconducting NbTi Superfine Filament Composites with Diameters < 0.1µm", Cryogenics, vol. 25, October, 1985, showing critical current density at 5T and 4.2°K versus NbTi filament diameter as calculated (0) and as measured experimentally (.).
Figure 2 is from L.R. Motowidlo, H.C. Kanithi, and B.A. Zeitlin, "NbTi Superconductors with Artificial Pinning Structures", To be published, presented as paper #HX-01 at ICMC/CEC, Los Angeles, CA, July 25, 1989, showing critical current density versus applied magnetic field for three wire sizes corresponding to NbTi dimensions of 237A°, 592A°, and 968A° (A, B, and C, respectively).
Figure 3 shows the design of a monofilament billet containing alternating layers of Nb and Ti sheet wrapped around a Nb46.5wt%Ti core.
Figure 4 shows a plot of current density (5T, 4.2K) versus applied magnetic field for a 0.21mm (.0084") diameter Nb/Ti composite fabricated in accordance with the invention.
Figure 5 shows a plot of current density versus average layer thickness for the Nb/Ti composite fabricated in accordance with the invention. The average layer thickness is the average of the Nb and Ti layer thicknesses at the testing size as extrapolated from the starting sheet thicknesses.
Figure 6 shows a plot of current density versus applied magnetic field for three 0.21mm (.0084") diameter samples of the composite fabricated in accordance with the invention: A) Non-heat treated; B) Heat treated (750°C, 1 hr.) at 0.21mm (.0084"); C) Heat treated (730°C, 1 hr.) at 1.29cm (.508") followed by drawing to 0.21mm (.0084").
Figure 7 is a schematic diagram representing the variations in Nb and Ti concentration in the layers of the composite manufactured in accordance with the invention.
Figure 8 is a schematic diagram of a monofilament billet containing a Ti core surrounded by an annulus of Nb.
Figure 9 is a schematic diagram of a second stage monofilament billet containing filaments produced from the billet of Figure 8.
Figure 10 is a schematic diagram of a multifilament billet containing filaments produced from the billet of Figure 9.
Figure 11 is a diagram showing the effect of elongation on two segments of chopped, copper-free monofilament wire of the type shown in Figure 8.
Figure 12 shows the design of a monofilament billet containing alternating layers of Nb, Ta and Ti sheet wrapped around a Nb46.5%Ti core.
Figure 13 is a schematic diagram of a monofilament billet containing sheets of Nb15wt%Ta and Ti wrapped around a Nb46.5wt%Ti core;
Figure 14 is a schematic diagram of a partially alloyed sheet;
Figure 15 is a schematic diagram of a monofilament billet containing sheets of Ta wrapped around a Nb core;
Figure 16 is a schematic diagram of the monofilament of Figure 15 after extrusion into a rectangular bar;
Figure 17 is a schematic diagram of a monofilament billet containing sheets of Nb46.5wt%Ti, Nb, and Ti wrapped around a Nb46.5wt%Ti core; and
Figure 18 is a schematic diagram of a monofilament billet containing sheets of Nb46.5wt%Ti and Ti40wt%Ta wrapped around a Nb46.5wt%Ti core.

In a preferred form of the present invention, sheets of pure transition metal are layered and then wrapped around a core. When this material is processed, small layer thicknesses are quickly and easily obtained. During processing, ductile superconducting material is formed at the interfaces of the layered sheets such that approximately one half of the sheet thicknesses remain unreacted. These unreacted layers of transition metal afford pinning within the composite when reduced to <1000A° thick. The presence of pinning sites in the composite allows the development of superior J_{c} at low magnetic field (1T-5T). Here, a pinning site is defined as an interface between normal and superconducting material. In general, the greater the pinning site density within the composite, the better the low field J_{c}.

The thickness of the normal and superconducting layers is critical to the ultimate performance of the composite. If the layer thicknesses are too large, i.e., not on the order of the fluxoid spacing at the particular magnetic field, then inefficient pinning results. On the other hand, if the layers are reduced too much, mechanical and diffusional problems are introduced, as are proximity effects, serving to degrade the critical current density and upper critical field of the composite.

According to the invention, a composite material utilizing alternating layers of transition metal was fabricated as described in the following non-limiting example:

### EXAMPLE I

The process began by constructing a copper clad monofilament billet containing alternating layers of Nb and Ti around a Nb46.5wt%Ti core (see Figure 3). Nb and Ti layers were chosen in the hope that the layers might be reacted at a later point in the processing. The layer thicknesses were selected so that after this reaction, thin layers of unreacted Nb and Ti would remain to act as pinning sites, while the rest of the material would be NbTi alloy. These considerations resulted in a Nb to Ti ratio of 5:4 by volume.

After assembly, the monofilament billet was electron-beam welded shut in vacuum and then hot isostatically pressed at 650°C for four hours at a pressure of 104 MPa (15 ksi). The billet was then machined to 5.08cm (2.0") in diameter for extrusion. Prior to extrusion, the billet was heated to 650°C, which temperature was maintained for two hours. The billet was then extruded at 650°C to 1.27cm (0.5") in diameter. The extruded rod was cold-drawn to 0.76mm (0.03") in diameter, at which point the copper jacket was removed and the material was restacked in a Nb lined copper can, the Nb here, as in the case of the monofilament, serving to prevent copper contamination of the material. The new billet thus produced contained almost 4000 filaments within a thin Nb matrix.

The restack billet was processed in just the same way as was the monofilament billet, ultimately being drawn to several wire sizes for J_{c} testing. A standard four point probe was used to measure the I_{c} of helically wound samples at 4.2 K. The voltage laps were spaced 22 cm apart. Figure 4 shows a representative J_{c} versus applied field curve for the non-heat treated Nb and Ti material. Indeed, although the plot is for a 0.21mm (.0084") diameter wire, the data from the other samples tested (0.75mm (.0297") - 0.11mm (.0045") diameter) fell very nearly on the same curve. The J_{c}'s were calculated over the filament and Nb matrix areas, excluding both the copper and the outer annulus of Nb that was included as insurance against copper contamination. This annulus, 1.14mm (.045") thick at the 5.08cm (2.0") restack billet diameter, could easily be eliminated in future designs, and hence was not considered in the J_{c}.

As Figure 4 shows, the product of Example I displayed remarkably high J_{c}'s considering that only pure Nb and Ti sheets went into the bulk of the composite. The highest 5T J_{c} measured was 2175 A/mm² for the 0.21mm (.0084") diameter wire. H_{c}2 was estimated at 10.2T. Based on data acquired from a control material that contained only Nb46.5wt%Ti cores in a Nb matrix, the NbTi core in the wrapped foils was eliminated from the J_{c} calculations, allowing an estimate of J_{c} within the Nb and Ti layers. For the 0.21mm (.0084") wire at 5T and 4.2 K, the J_{c} in this region was estimated at 3250 A/mm². That these current densities were achieved without special heat treatment implies that some alloying of the Nb and Ti layers must have occurred during processing. Since the processing of both the monofilament and restack billets involved hot isostatic pressing and hot extrusion, there was ample opportunity for NbTi formation.

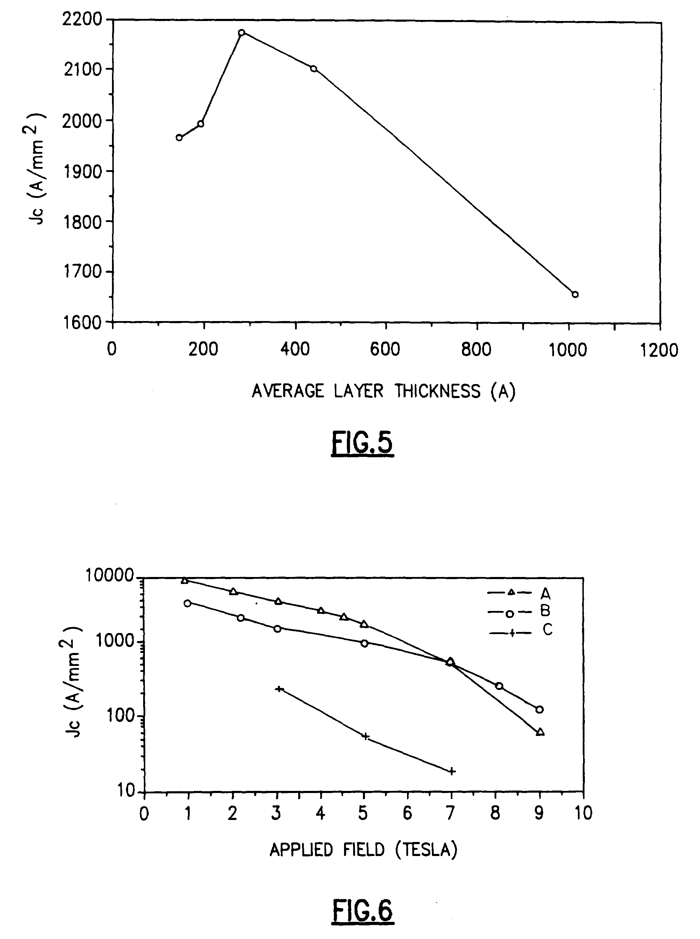

Figure 5 shows a plot of J_{c} versus the average layer thickness in the composite, that is, the average of the Nb and Ti layer thicknesses at the testing size as extrapolated from the starting sheet thicknesses (0.46mm (.018") average). The peak J_{c} occurred at between 300A° and 400A°. Note the similarity between this curve and that produced by Hlasnik et al. (Figure 1), indicating that the same sort of pinning mechanism is at work.

The application of a 750°C, 1 hour reaction heat treatment - chosen so as to prevent -Ti formation - was found to reduce J_{c} for wire diameters ranging from 1.29cm (.508") to 0.11mm (.0045"). The application of a heat treatment followed by drawing to the sample size tended to increase J_{c} at that size in the 7-9T range, but J_{c} remained inferior over the lower field region, where pinning is most important. The plot in Figure 6 shows these effects. The poor low field J_{c}'s observed suggests that the high temperature heat treatment tended to homogenize the material, thereby lowering the degree of pinning afforded by the Nb and Ti layers.

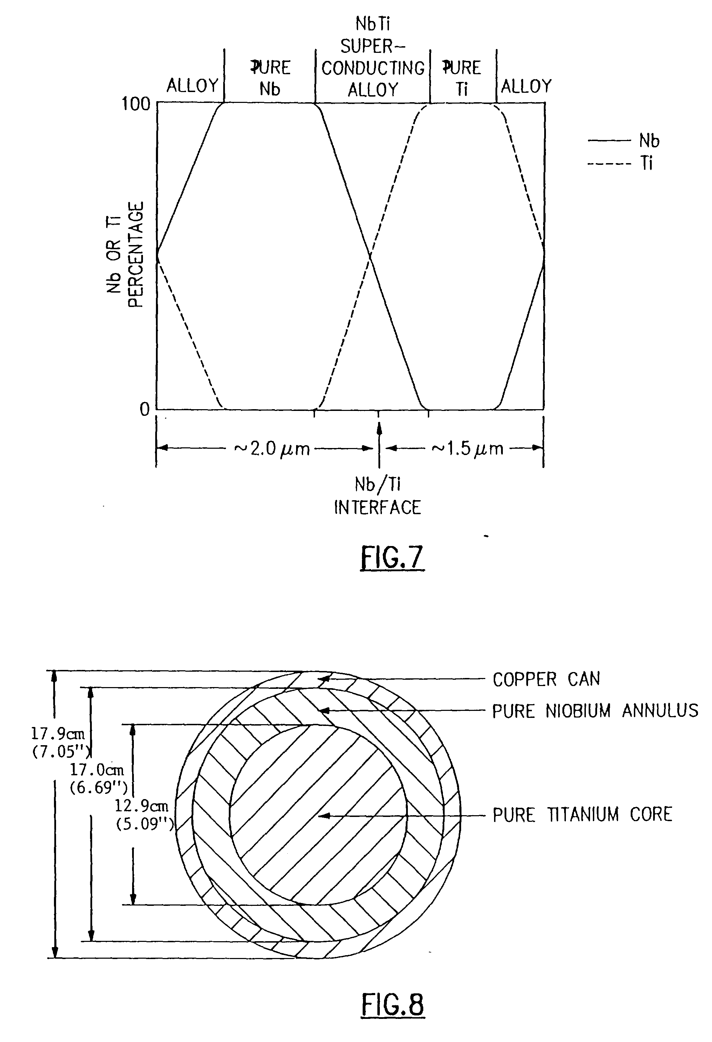

An EDS (energy dispersive spectroscopy) examination of the composite at the 1.29cm (.508") diameter extrusion size revealed that neither the Nb nor the Ti layers were completely reacted, but that significant diffusion had occurred along the Nb/Ti interfaces. This effect is shown schematically in Figure 7, where the exact extent of the NbTi superconducting region is a matter of definition (i.e., relative to Nb and Ti concentrations). Both the Nb and Ti contribute to the flux pinning in the composite.

Other methods of practicing the invention are set forth in the following non-limiting examples:

### EXAMPLE II

The monofilament billet shown in Figure 8 is suited to the production of multifilament wire having more than 4500 6 µm diameter filaments. To produce wire of this kind, two first stage and two second stage monofilament billets must be constructed and processed. Each of the first stage monofilament billets contains a 61cm (24") long solid Ti ingot surrounded by an annulus of Nb that can either be built up from sheet or machined from a solid. As the figure indicates, each Nb/Ti assembly is inserted into a thin Cu can. The cans are welded shut and then evacuated. The billets are prepared for extrusion by heating them at 650° C for 3 hours. They are then extruded at 650° C from a 18.1cm (7.125") diameter liner to 2.54cm (1.00") in diameter. The extrusions are cropped to remove the excess copper at the noses and tails and are then cold-drawn to 1.60mm (0.063") flat-to-flat hexagonal wire. This material is cut into 56cm (22") long filaments. Nitric acid is used to pickle off the copper on the filaments prior to assembly of the second stage monofilaments. (Because the copper cladding is so thin, the Nb on the filaments will have the hex shape that helps to minimize void space in restacked billets.)

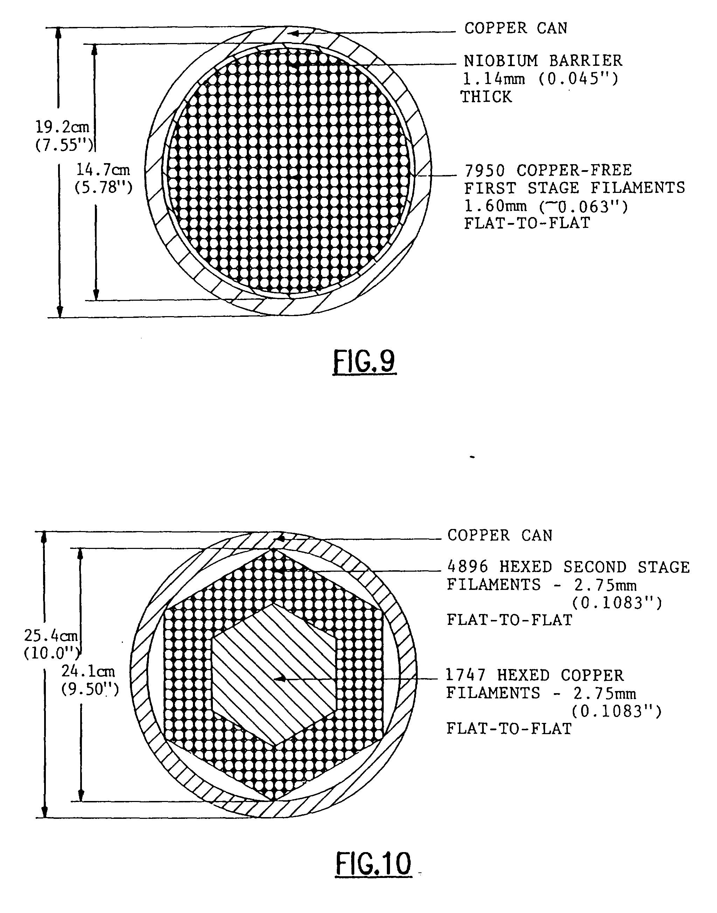

The design of the second stage monofilament is shown in Figure 9. Two such billets are assembled, each as follows: The copper can is lined with a Nb barrier to prevent copper contamination during processing. Approximately 7950 of the copper-free filaments are assembled into an hexagonal close-packed array. The copper can, with the barrier, is slipped into position around this array. After the two billets have been assembled, their noses and tails are attached via electron beam welding in vacuum. The billets are then hot isostatically pressed (HIP'd) at 650° C and 104 MPa (15 ksi) for 4 hours. Prior to extrusion, the billets are machined to 17.9cm (7.05") in diameter. Next, they are preheated, extruded, and cropped in the same way as the first stage billets. The 2.54cm (1.0") extrusion is drawn to 2.75mm (0.1083") flat-to-flat hexagonal wire. OFHC copper is also drawn to hexagonal wire at this size. These materials are then cut into 88.9 cm (35") lengths for incorporation in the multifilament billet.

The design of the multifilament billet is shown in Figure 10. After cleaning, the hexed copper and second stage filaments are assembled as an array having the proportions indicated by the figure. The copper can is slipped into position around the array and copper filaments are packed at the perimeter to ensure a tight fit in the can. After the nose and tail have been attached via electron beam welding in vacuum, the multifilament billet is HIP'd at 650° C, 104 MPa (15 ksi) for 4 hours. The billet is machined to 25.0cm (9.85") in diameter, resulting in a copper-to-non-copper ratio of 1.3:1 by volume, ensuring adequate electrical and thermal stability. The billet is preheated at 650° C for 3 hours and is then extruded at 650° C from a 25.4cm (10.0") diameter liner to 6.35cm (2.5") in diameter. This extrusion is cropped and then drawn to a 0.65mm (0.0255") diameter final wire size.

This processing scheme will result in wire with 6 µm diameter filaments, each filament being composed of ^{~}300°A diameter Ti sub-filaments in a NbTi matrix. The NbTi composition will be about Nb30wt%Ti depending on the extent of diffusion. The interfaces between the NbTi and the Ti serve as flux pinning sites in the final composite.

Configurations of Nb and Ti other than that described here could easily be utilized to good effect. For example, the positions of the Nb and Ti in the first stage monofilament could be reversed. The relative amounts of Nb and Ti could also be varied to suit a particular application. To reduce the number of extrusions, the first stage monofilament billet might incorporate a solid Nb (or Ti) matrix with a number of holes drilled through it to accept Ti (or Nb) rods. With a sufficient number of rods, one could avoid the second stage monofilament and go straight to multifilament fabrication. None of these variations constitutes a major departure from the essentials of the invention.

A processing scheme like that described above can be used to produce any composite wherein NbTi is accompanied by nearly pure Nb, Ti, or both Nb and Ti. In particular, it should be mentioned that one could create a composite which, after processing, contains NbTi filaments in a Nb matrix -- i.e., the composite initially contains Ti filaments which, in the course of processing, are fully reacted with a Nb matrix. A composite containing NbTi filaments in a Nb matrix is described in patent no. 4,803,310, held by Intermagnetics General Corporation.

The 4,803,310 patent in no way contemplates the reaction of pure transition metals to form the artificially pinned composite. Indeed, in referring to the equivalent of the Nb annulus in Figure 8, the 4,803,310 patent explicitly states (section 2, lines 47 and 48) that the "metal used should be one that will not diffuse, or will diffuse only nominally, into the core filaments." this requirement is in stark contrast to the processing demands of the present invention. Of course, in the more general case, where the core material is not fully reacted during processing, the resulting composite will be completely unlike that described in the 4,803,310 patent.

### EXAMPLE III

Another method by which to produce the periodic structure in the composite is via powder metallurgy. Depending upon the shapes of the powder grains, a mix of transition metal powders becomes, after sufficient elongation, a complex array of filamentary or ribbon structures. Although such a system is intrinsically less ordered than the sheet or filament systems discussed previously, it nonetheless possesses the layering characteristic of the invention.

A preferred method of fabrication utilizing powders is as follows:
1. Obtain the chosen transition metal powder -- Nb and Ti, for example. The powder grains should be spherical so that filament thicknesses can be predicted with some accuracy. Powders fabricated by the rotating electrode process are nearly spherical, and so are suitable for this application. The powder grains must be relatively large ( 150 m in diameter) so that one can avoid oxygen contamination problems brought about by too great a surface-to-volume ratio in the grains. The grain size should be the same for all constituent powders.
2. Mix the powders in the appropriate ratio. For Nb and Ti, the ratio is approximately 1:1 by volume.
3. Compress the powder mixture into a copper can lined with a diffusion barrier. The diffusion barrier is necessary to prevent copper contamination in the powder core. Obviously, the barrier material must be one (Nb or Ta, for example) that does not react with copper. The powder mix may be pressed into the can by any mechanical means, provided that the method in no way contaminates the powder.
4. After the can is sealed in vacuum, it is hot isostatically pressed (HIP'd) at a temperature, pressure, and time sufficient to ensure maximum densification of the powder mix. For a Nb and Ti system, 650°C, 104 MPa (15 ksi) for 4 hours is an adequate HIP.
5. Machine a solid core of the powder mix out of the HIP'd assembly. Insert this core into a copper extrusion can lined with a diffusion barrier composed of the same material as was used in the HIP can.
6. From this point on, the processing is the same as for the earlier example I composite, including restack, except that the monofilament billet is not HIP'd, since its core is already fully dense. The final wire size will be that at which the filaments in the composite are less than 0.1 µm thick as extrapolated from the original powder size.

### EXAMPLE IV

The powder metallurgy approach has several drawbacks. Most significant is the fact that oxygen contamination resulting in processing difficulties is always a threat. In addition, one cannot precisely control particle sizes or distributions. An alternative approach, one that circumvents these problems, is the use of chopped wire instead of powder.

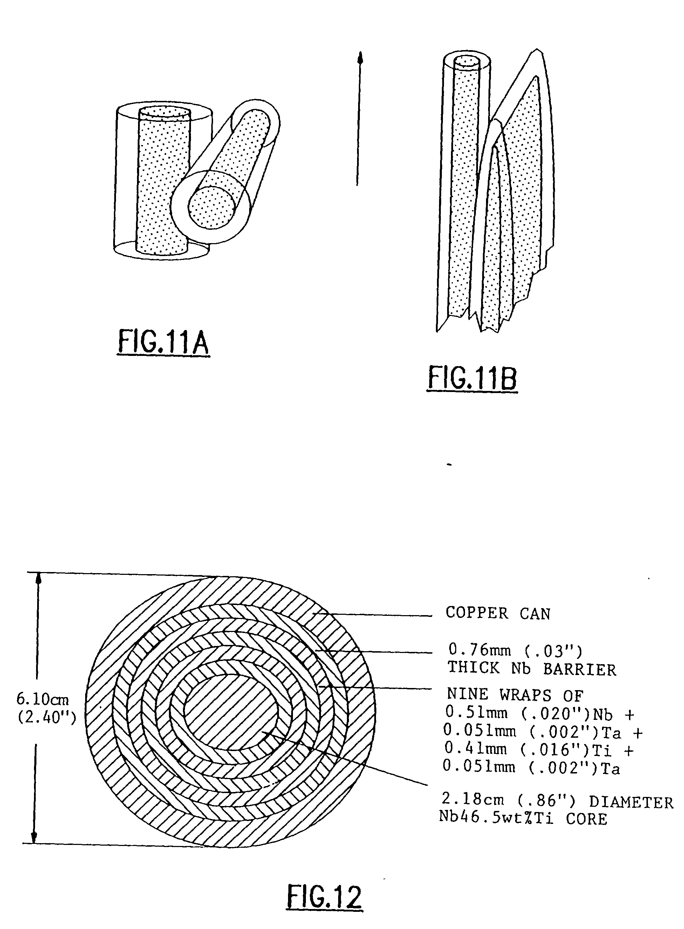

There are two ways in which chopped wire can be used to create the necessary layered structure. The first technique is to obtain wires made of the required transition metals, chop them into pieces, and mix them in the right proportions for incorporation into a monofilament extrusion can. The second technique is to fabricate a monofilament wire containing one or more layers of the necessary transition metals, chop it up at the appropriate size, and put the pieces into the extrusion can. This latter method has the advantage that achieving a good mix of materials is not a problem, since every segment of wire contains the correct ratio of metals. Elongation of this type of composite results in a dense, convoluted mix of filaments, ribbons, and elements with morphologies that are somewhere in between. Figure 11 shows this effect schematically. Figure 11A shows two segments of wire of the type shown in Figure 8.

The segments are orthogonally oriented, as many of the segments in the monofilament would be. Figure 11B shows the effect of elongation in the direction of the arrow; one segment forms a ribbon while the other remains a filament. The chopped wire approach thus represents a combination of the three systems described previously: sheet, filament, and powder.

Regardless of the type of wire to be used in the monofilament, it should be chopped into segments having a length-to-diameter ratio of about 1:1. The wire diameter should be greater than 0.25mm (0.01") in order to gain a surface-to-volume advantage over powders. The monofilament can must be lined with a diffusion barrier to prevent copper contamination. Assembly and processing is the same as for the Example III composite, except that the monofilament is simply HIP'd and extruded rather than going through the separate densification HIP. While it is desirable to extrude a fully densified core and thereby maximize the yield, the relatively large segments of chopped wire are unlikely to bond sufficiently during a HIP to allow the subsequent machining of a solid core.

Another method of providing extended interfacial areas between adjacent "normal" transition metal bodies is to stack alternate sheets thereof together with reduction and appropriate heat treatment to create the diffusion layer of superconductor. The sheets can be folded, slit and otherwise treated to give almost any final desired arrangement of interfaces. Other mechanical combining, reducing and heat treating steps may be used to create the desired diffusional area of superconducting alloy.

In a preferred form of the invention described in the preceding examples, a superconductor is produced by the steps of combining a plurality of layers of metal sheets to form a composite structure. The sheets are preferably pure transition metals - niobium, titanium, zirconium, or vanadium, alternate sheets being formed of different transition metals. The resulting composite structure is mechanically reduced sufficiently so that each transition metal sheet is less than 1000A° thick. In the course of reduction, the composite is subjected to sufficient temperatures for sufficient times such that the transition metal layers are partially reacted to form a ductile superconducting material between the transition metal layers.

Approximately one half by volume of the transition metal layers remain unreacted. These unreacted layers afford efficient flux pinning within the composite when the layers are reduced to the <1000A° final size. In other embodiments, powders and filaments can be used instead of initial layers.

The examples specifically given above focus on binary alloys of the transition metals, but the same principles can be applied to systems involving more than two transition metals. Alloys composed of more than two metals frequently offer significant advantages over binary alloys like NbTi. NbTiTa, for example, has been shown to have higher critical current densities at 1.8K than conventional Nb46.5Ti through its full magnetic field range (see "Innovations in the Design of Multifilamentary NbTi Superconducting Composites for the Supercollider and Other Applications", E. Gregory, T.S. Kreilick, and J. Wong, Supercollider I, Plenum Press, 1989). This behavior makes NbTiTa preferable to NbTi in low temperature, high field applications. Other alloys involving multiple transition metals offer different advantages. Unfortunately, these alloys are usually expensive to fabricate and processing them into wire form by conventional means is often difficult, if not impossible. The application of the invention to NbTiTa and other alloys composed of more than two transition metals greatly reduces the cost and improves the fabricability of superconducting wires incorporating them. In addition, the ability to use more than two transition metals allows a degree of flexibility in the design of artificially pinned superconducting composites that is not available in simpler, two component systems.

A NbTiTa alloy can be produced in a conductor by the methods described in Example I for NbTi. The only difference in fabrication is that a 0.051mm (0.002") thick layer of annealed Ta sheet is inserted between the layers of Nb and Ti in the monofilament. The layered structure of Nb, Ta, and Ti can be created by coiling an assembly of four sheets around the core: 0.51mm (0.020") Nb +0.051mm (0.002") Ta + 0.41mm (0.016") Ti + 0.051mm (0.002") Ta. This arrangement ensures that, the Nb and Ti are never in direct contact. Once the monofilament is assembled, processing continues exactly as described in Example 1 of the parent applications.

According to this embodiment of the invention, a composite material utilizing alternating layers of transition metal can be fabricated as described in the following non-limiting example:

### EXAMPLE V

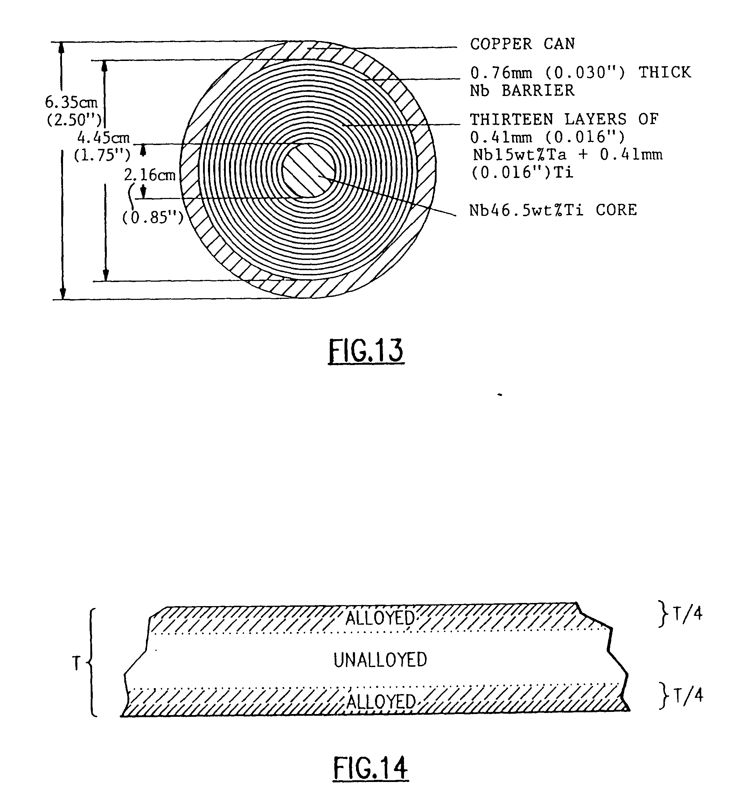

The process begins by constructing a copper clad monofilament billet containing alternating layers of Nb, Ta and Ti around a Nb46.5wt%Ti core (see Figure 12). Nb, Ta and Ti layers are utilized so that the alloy NbTaTi is formed via the reaction of the layers during processing. The layer thicknesses are chosen so that after this reaction, thin layers of unreacted Nb and Ti will remain to act as pinning sites, while the rest of the material is NbTaTi alloy. These considerations result in a Nb to Ti to Ta ratio of 10:8:1 by volume.

After assembly, the monofilament billet is electron-beam welded shut in vacuum and then hot isostatically pressed at 650°C for four hours at a pressure of 104 MPa (15 ksi). The billet is then machined to 5.08cm (2.0") in diameter for extrusion. Prior to extrusion, the billet is heated to 650°C, which temperature is maintained for two hours. The billet is then extruded at 650°C to 1.27cm (0.5") in diameter. The extruded rod is cold-drawn to 0.76mm (0.03") in diameter, at which point the copper jacket is removed and the material is restacked in a Nb lined copper can, the Nb here, as in the case of the monofilament, serving to prevent copper contamination of the material. The new billet thus produced contains almost 4000 filaments within a thin Nb matrix.

The restack billet is processed in just the same way as is the monofilament billet, ultimately being drawn to approximately 0.22mm (.0085") in diameter, where the Nb and Ti layers are less than 500°A in thickness, a size at which these layers operate as flux pinning sites within the composite.

Because the Ta layer is thin relative to the Nb and Ti, the processing results in complete diffusion of the Nb and Ti across the Ta. The final composite thus contains layers of NbTiTa separated by unreacted regions of Nb and Ti that serve as pinning layers. Approximately half of the Nb and half of the Ti by volume are reacted with the Ta, producing an average composition near Nb23wt%Ti34wt%Ta, although strong compositional gradients are, of course, present.

This processing scheme can be varied in several ways, all of which are in accordance with the invention. The variations arise primarily from two considerations-layer thicknesses and layer sequencing. These factors impact the multiple transition metal composite as follows:
1. It is not important which, or how many of the constituent transition metal layers are made relatively thin, provided that at least one metal is maintained in a nearly pure state to provide flux pinning in the composite. In the composite described above, any two of the layers Nb, Ti, and Ta could be made relatively thin so as to be completely consumed in the diffusion process.
2. In some cases, it may be desirable to utilize thick layers of all the constituent metals in order to produce a composite containing layers of several different binary superconducting alloys rather than a ternary (or higher order) alloy. If a layer of Ta as thick as the Nb were used in the composite described above, the processing would result in incomplete diffusion across the Ta and the composite would thus be threaded with layers of NbTa and TiTa, both of which are superconductors.
3. Changing the order of the constituent layers can result in a fundamentally different composite. In the above composite, if the sequence Ta + Nb + Ti + Ta were utilized instead of Nb + Ta + Ti + Ta, binary NbTi would be formed, while NbTiTa might not be formed at all due to the doubling of the Ta. Clearly, the resulting composite would be very different from that produced by the original sequence.
4. Among the possible variations on the Example V composite, one that contains layers of NbTi and NbTiTa is of particular interest, since both of these alloys are excellent superconductors. Such a composite can be fabricated by wrapping the following assembly of sheets around the NbTi core in the monofilament: 0.51mm (0.020") Nb + 0.051mm (0.002") Ti + 0.051mm (0.002") Ta + 0.41mm (0.016") Ti. Processing then proceeds exactly as described in Example I, above. The diffusion results in the formation of NbTiTa in the region of the thin Ti and Ta, while NbTi is formed at the interface of the Nb and the Ti. Approximately one half by volume of each Nb and each thick Ti layer remains unreacted to ensure flux pinning within the composite. The NbTiTa composition is thus near Nb27wt%Ti33wt%Ta, while the NbTi composition is approximately Nb30wt%Ti.

Not all of the transition metal superconducting alloys lend themselves to the processing temperatures and times utilized in the fabrication of the Example V prototype. For example, Laves phase materials like V₂(Hf_{0.5}Zr_{0.5}) generally form at temperatures above 900°C, well in excess of the 650°C of Example V. That temperatures and times may need to be varied in order to form certain of the alloys implicitly covered by the invention in no way impacts the invention itself. A knowledge of diffusion within transition metal systems is necessary in order to apply the invention. Given that knowledge, it is a trivial matter to adjust the processing parameters as is appropriate for a particular system in order to take advantage of the invention.

Aside from core materials, the multilayer composites described in the above examples are composed solely of pure metals. Such composites are undoubtedly useful, but the efficiency of the superconductor fabrication can be greatly improved if one or more of the constituent layers used in the monofilament billet is an alloy, rather than a pure metal. The alloy, which may or may not be a superconductor, can be layered with pure metal or with another alloy, depending upon the superconducting properties ultimately desired. Diffusion in the course of processing this material creates layers of superconducting alloy, which may be similar to, but is not identical with, the initial alloy.

That alloy layers, rather than pure metal layers, are utilized in the present invention in no way affects the core principles of the invention. These principles can be briefly stated as follows:
1. A composite characterized by alternating layers of two or more metals.
2. Processing the composite at elevated temperatures in order to:
   a. bond the metal layers, thus facilitating reduction of the composite; and
   b. create, by diffusion, layers of superconducting material at the metal-to-metal interfaces of the composite, while also maintaining regions of unreacted metal.
3. Mechanically reducing the composite so that the reacted and unreacted layers are less than 1000A° in thickness.

In the preceding examples, these principles are only applied to pure metal layers, primarily because pure metals are generally less expensive, and thus more desirable, than alloys. However, for reasons related to fabricability and improved performance, the benefits of alloy layers will sometimes outweigh the added costs. The use of alloy layers in accordance with the invention is the focus of the present application.

U.S. Pat. No. 4,803,310, held by Intermagnetics General Corporation, describes a composite characterized by a layered structure of a superconducting alloy and a non-superconducting - i.e., "normal" - metal, the latter serving to pin the flux lines in the composite. While generally similar to the composites of the present invention, the IGC composites incorporates as a normal metal one that "will not diffuse, or will diffuse only nominally" (volume 2, lines 47-48) into the superconducting alloy. By contrast, the present invention requires that a significant fraction of the normal metal diffuses into the adjacent layers in the composite. Only in this way are the desired superconducting layers created.

In this embodiment alloys are used in order to expedite the formation of superconducting material during reaction. In general, two types of alloys will be of use in this embodiment:
I. Normal metal alloys, such as NbTa, TiTa, or HfZr, which simplify ternary (or higher order) superconductor fabrication, but which do not themselves superconduct at useful magnetic fields; and
II. Ductile superconducting metal alloys, such as NbTi or NbZr, which can be combined with normal metals (pure or alloy) to form layers of superconducting material having better superconducting properties than the original alloy.

These cases will be dealt with separately.

### CASE I

The fabrication of composites, containing ternary superconductors like NbTiTa is difficult if only the pure metals are used, because at least one of the metals must diffuse completely before the superconductor will form. This is a slow process, requiring binary formation (NbTa and TiTa, e.g.) before the ternary (NbTiTa) can be realized. A two component system is much more efficient, with all diffusion going towards formation of the superconductor, rather than intermediate alloys. For ternary (or higher order) superconductors, the two components obviously must include at least one alloy. NbTiTa, for example, is ideally formed from a NbTa alloy and pure Ti. Other possibilities are TiTa + Nb, NbTi + Ta, NbTi + TiTa, and NbTi + NbTa, where the latter three are Case II combinations. Alloys like NbTa and TiTa are what will be termed "precursor alloys", by which is meant that the alloys are not themselves superconducting at operating fields, but are necessary for the formation of a ternary (or higher order) superconductor.

It is not necessary for precursor alloy layers to be wholly alloy, since the superconductor need not extend all the way across these layers. An adequate layer of alloy material can be created on the surface of an otherwise pure metal by depositing relatively thin layers of other metals onto the surface and then subjecting the combination to sufficient temperatures for sufficient times to react the metals at the layer surface. The deposition of a second metal can be accomplished by means such as sputtering the second metal onto the first or by coreducing the first and second metals to the point where they are bonded. After reaction, the material is layered with one or more other metals to make a composite in just the same way as is 100% alloy material.

It will be noted that the thin alloy layer described here could just as easily be incorporated as a separate layer of 100% alloy. while this is certainly true, it will frequently be the case that the desired alloy composition will not be readily available or will be prohibitively expensive. In such cases, the above methods produce material suitable for use in the alloy-based, artificially pinned composite. Another advantage to these methods is that the alloy layer is thoroughly bonded to the pure metal substrate prior to fabrication of the monofilament, which can only be of help in later processing.

In accordance with the invention, an artificially pinned superconducting composite can be fabricated as described in the following non-limiting examples, where Example I involves the use of a 100% alloy sheet and Example II involves partially alloyed sheet:

### EXAMPLE VI

The process begins by constructing a copper clad monofilament billet containing alternating layers of Nb15wt%Ta alloy and pure titanium around a Nb46.5wt%Ti core (see Figure 1). Reaction of the layers during processing forms a NbTiTa superconducting alloy at the interfaces of the otherwise normal NbTa and titanium layers. The layer thicknesses are chosen so that after this reaction, thin layers of unreacted NbTa and Ti will remain to act as pinning sites within the ternary conductor. These considerations result in a Nb15wt%Ta to titanium ratio of 1:1 by volume. For this example, the thickness of both layers in the monofilament is chosen to be 0.41mm (0.016"). The overall core length (sheet width) is 15.2cm (6.0"). Extra niobium is placed at the can/core interface in order to prevent reaction between the titanium layers and the copper can. All components of the billet are thoroughly cleaned prior to billet assembly.

After assembly, the monofilament billet is electron beam welded shut in vacuum and then HIP'd at 650°C for four hours at a pressure of 104 MPa (15 ksi). The billet is then machined to 5.08cm (2.0") in diameter in order to fit a 5.40cm (2.125") extrusion liner. Prior to extrusion, the billet is heated at 650°C for two hours. The billet is then extruded at 650°C to 1.27cm (0.50") in diameter at a rate of 38.1cm/min (15 ipm). The extruded rod is cold-drawn at an areal reduction rate of 20% per die pass to 0.76mm (0.030") in diameter. This wire is straightened, cut into 12.1cm (4.75") lengths, and then immersed in a nitric acid solution in order to pickle off the copper cladding. The resulting filaments are stacked into a copper extrusion can (6.35cm (2.50") outer diameter by 4.45cm (1.75") inner diameter) lined with 0.25mm (0.010") of niobium, the niobium here, as in the case of the monofilament, serving to prevent copper contamination of the material. The new billet thus produced contains almost 4000 niobium-clad filaments.

The restack billet is processed in just the same way as the monofilament billet, ultimately being drawn to approximately 0.25mm (0.010") in diameter, where the NbTa and titanium layers are less than 1000A° in thickness, a size at which these layers provide effective flux pinning within the composite. The diffusion at the NbTa/Ti interfaces results directly in the formation of superconducting NbTiTa, rather than the intermediate binary alloys that would be formed if only pure metal layers were utilized. Approximately half of the titanium and half of the NbTa by volume reacts, resulting in an average composition of Nb18wt%Ta32wt%Ti at the interfaces, although strong compositional gradients are, of course, present.

### EXAMPLE VII

In order to minimize the need for expensive materials like NbTa alloys, the alloy layer of Example I can be replaced by a partially alloyed material. As indicated in Figure 2, such a material is one in which the alloy is carried on the surface of an otherwise pure metal, extending into the layer only about one quarter of the total layer thickness. For niobium and tantalum, such a layer can be created by extruding a monofilament billet containing tantalum around a niobium core, removing the copper cladding, rolling the result into sheet, applying an intermediate heat treatment in the course of reduction, and annealing the final sheet. The intermediate heat treatment serves to diffuse the tantalum into the niobium; it is applied at a relatively large sheet thickness in order to allow better control over the extent of diffusion. The final anneal primarily serves to restore the workability of the material, although some diffusion occurs at this stage also.

In addition to avoiding costly melting operations, the method described here for the fabrication of partially alloyed sheet allows great flexibility in the tantalum content of the NbTiTa. By simply extending or abbreviating the heating time, a precursor alloy sheet having lower or higher amounts of surface tantalum can be produced, which directly affects the tantalum content in the ternary. The detailed processing steps for the fabrication of a Nb/Ta precursor alloy sheet are given below.

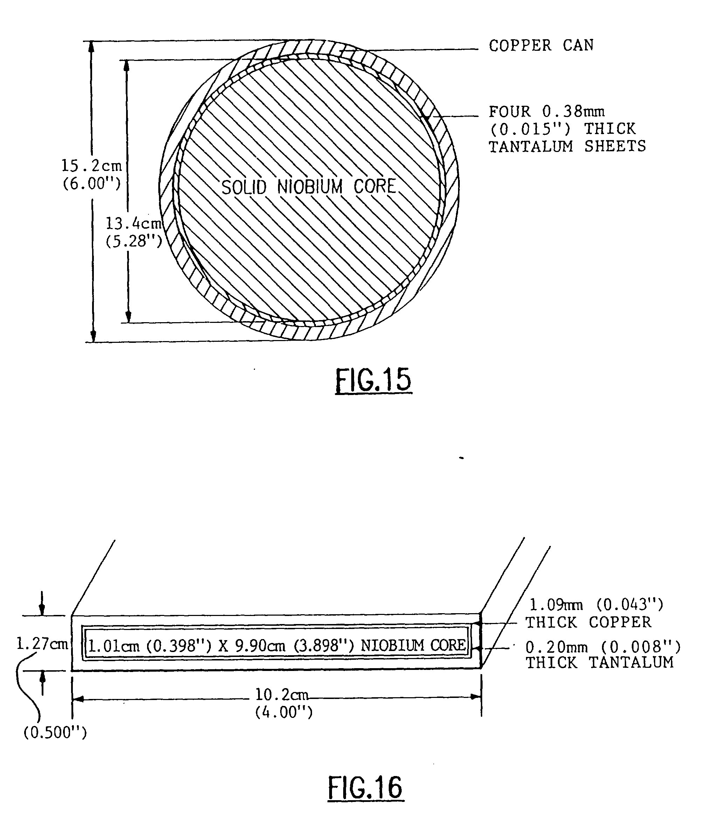

A typical can design for the Nb/Ta billet is shown in Figure 15. Four 0.38mm (0.015") thick by 30.5cm (12.0") long sheets of high purity (99.99% or better) tantalum are wrapped around a 13.4cm (5.28") diameter, 30.5cm (12.0") long niobium core, and this assembly is inserted into a copper extrusion can. All of these components are cleaned prior to billet assembly. After assembly, the copper nose and tail of the billet are electron beam welded into place in vacuum, and then the billet is prepared for extrusion by heating at 650°C for two hours. The billet is extruded at 650°C to a rectangular cross section 10.2cm (4.0") wide by 1.27cm (0.50") high, as shown schematically in Figure 16.

The extruded bar is immersed in a nitric acid solution in order to pickle off the copper, and the resulting Nb/Ta bar is cold rolled at an areal reduction rate of 10% per pass to a width of 15.2cm (6.0") and a thickness of 2.54mm (0.10"). This material is thoroughly degreased with acetone and is then heat treated in vacuum to react the niobium and the tantalum. The heat treatment is at 1200°C for two hours. After the heat treatment, the sheet is rolled at the same reduction rate to a final thickness of 0.41mm (0.016"). The sheet is degreased and then given a final anneal in vacuum for one hour at 1000°C. The final strip is pure niobium except for a 0.10mm (0.004") thick layer of NbTa on each side. The average composition of this alloy layer is Nb15wt%Ta.

The precursor alloy strip is wound along with pure titanium sheet (also 0.41mm (0.016") thick) around a Nb46.5wt%Ti core, just as indicated in Figure 1 for the 100% alloy sheet. The processing of this billet then proceeds as explained in Example VI, above.

Diffusion during processing converts the bulk of the NbTa region (and an equivalent volume of titanium) into superconducting Nb18wt%Ta32wt%Ti. These superconducting layers are separated by pure niobium and titanium layers of comparable thickness. When the thickness is <1000A°, the pure metal regions provide efficient flux pinning within the ternary conductor.

### CASE II

In addition to normal alloys, alloys that are superconducting at operating fields can be utilized in accordance with the invention. In these situations, the diffusion during processing produces superconducting layers having improved properties relative to the original alloy. The improved layers may constitute all or only part of the initial alloy layers, depending upon the final properties desired. The primary advantage to the use of superconducting alloy layers is that it is much easier to improve an existing superconducting material than it is to create the improved superconductor from non-superconducting constituents.

The properties of a superconducting alloy can be altered in two ways, both of which are important to the present invention:
1. The concentrations of the constituent metals can be altered.
2. New metals can be added to the alloy.

In terms of the present invention, the first point refers to the combination of an alloy with one or more of the pure metals that constitute that alloy. NbTi+Nb and NbTi+Ti are examples of such combinations. The NbTi layer created by diffusion at a NbTi/Nb interface will necessarily contain more niobium (less titanium) than the original NbTi layer. Just the opposite is true at a NbTi/Ti interface. The diffusion thus results in a distinctly different alloy than is originally put into the composite, although the basic constituents are the same.

The second method by which to alter the properties of a superconducting alloy is to simply add to the alloy one or more metals that are not constituents of the alloy. In the present invention, this is accomplished by layering an alloy with a metal containing the desired additive. For example, NbTi can be layered with TiTa to produce, by diffusion, layers of NbTiTa superconductor.

In some cases, it may be desirable to completely react one or more of the layers in a composite. This is within the purview of the invention provided that regions of normal metal are maintained to act as pinning sites. If, for example, a billet containing layers of Ti+NbTi+Ti+Nb is constructed with relatively thin layers of titanium, the titanium will completely diffuse into the neighboring layers during subsequent processing. This surplus titanium has two important effects. First, the additional titanium offsets the titanium that would be lost to the niobium in a simple NbTi+Nb configuration. Second, the diffusion of titanium into the NbTi creates a region of high-titanium NbTi, which, generally speaking, gives higher J_{c} than standard NbTi alloy (Nb46.5wt%Ti, e.g.).

An interesting consequence of using superconducting alloys in the artificially pinned composite is that flux pinning becomes more complicated. When layers of the original superconducting alloy are present in the final composite, they may or may not contribute to flux pinning. That is, it may or may not be the case that at some magnetic field levels the initial alloy layers behave like normal metal layers, while the reacted layers remain superconducting. This will not occur unless the upper critical field (H_{c2}) of the newly created superconducting alloy exceeds that of the initial alloy. Suppose, for example, that the superconducting alloy AB is combined with the pure metal C to form the ternary superconductor ABC. If the H_{c2} of AB is 5T and the H_{c2} of ABC is 11T, then AB can provide flux pinning in the field range of 5-11T, but not in the range of 0-5T. This effect is actually only an extension of the basic invention, since "normal" metals like Nb are, in fact, superconducting at fields below about 1T, and so behave as described above in this very low field range.

In accordance with the invention, artificially pinned composites utilizing ductile superconducting alloy layers can be fabricated as described in the following non-limiting examples:

### EXAMPLE VIII

A monofilament billet in constructed as described in Example I, above, with the exception that Nb30wt%Ti is used in place of Nb15wt%Ta. Subsequent processing of the billet is also described in Example VI.

Approximately one half by volume of the NbTi and titanium layers react during processing, resulting in an average composition of Nb58wt%Ti in the reacted zone. This relatively high titanium content results in higher J_{c}'s than would be obtained if no diffusion occurred (i.e., relative to Nb30wt%Ti). Pinning within the composite is provided by the unreacted titanium layers when these layers are at their <1000A° final size.

### EXAMPLE IX

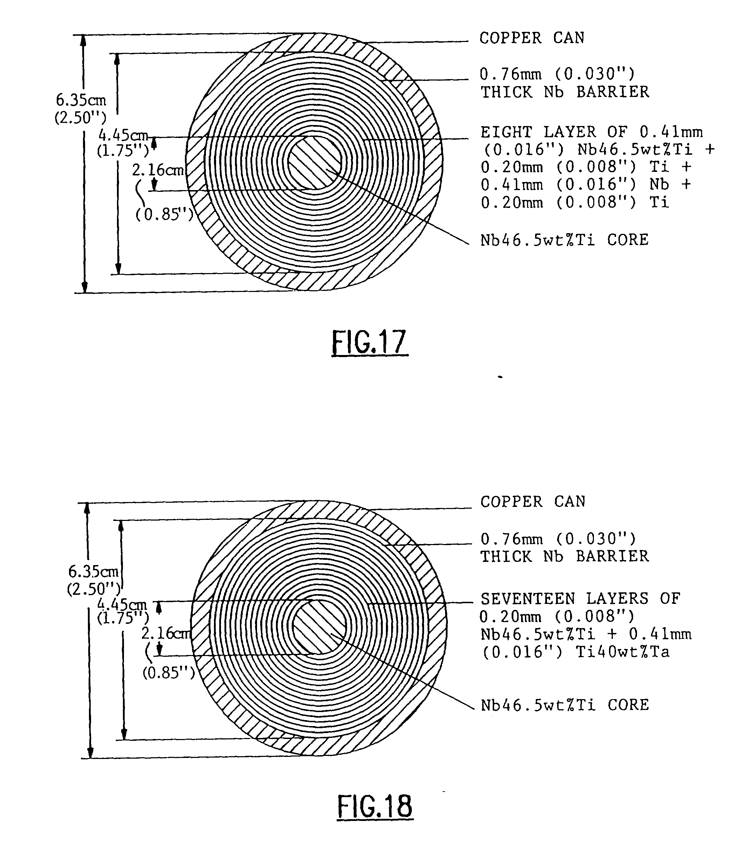

A monofilament billet is assembled in accordance with the diagram shown in Figure 17. Each layer in the billet consists of 0.41mm (0.016") thick Nb46.5wt%Ti + 0.20mm (0.008") Ti + 0.41mm (0.016") Nb + 0.20mm (0.008") Ti. The assembly and processing of the billet are exactly as described in Example I, above.

In the course of processing, all of the pure titanium in the composite is reacted with approximately one half by volume of the adjacent niobium and NbTi layers. The result is an average composition near Nb74wt%Ti at the NbTi/Ti interfaces and Nb35wt%Ti at the Nb/Ti interfaces. The unreacted niobium provides flux pinning in the final composite.

It has been assumed here that the titanium diffusion produces two fairly distinct regions corresponding to the NbTi/Ti and the Nb/Ti interfaces. If a lesser amount of titanium were utilized, or if more diffusion were allowed, a mixture of the two alloys given above would result. It will be seen that this situation is not significantly different than that described in the example, but is only more complicated.

### EXAMPLE X

A monofilament billet is assembled in accordance with the diagram shown in Figure 18. Each layer in the billet consists of 0.20mm (0.008") thick Nb46.5wt%Ti + 0.41mm (0.016") Ti40wt%Ta. The assembly and subsequent processing of the billet are as described in Example VI, above.

In the course of processing, all of the NbTi and approximately one half by volume of the TiTa are reacted, resulting in superconducting layers having the average composition Nb19wt%Ta39wt%Ti. The unreacted TiTa layers provide flux pinning within the ternary composite when reduced to their <1000A° final size.

## Claims

1. A Method for producing a superconductor which is superconducting at a high magnetic field comprising the steps of providing a plurality of metal bodies in the form of a composite structure, said metal bodies being selected from the transition metals niobium, tantalum, titanium, zirconium, hafnium or vanadium and alloys thereof which are not superconducting at said high field, alternate bodies being formed of different transition metals to form groups of at least two different metals in interfacial contact, mechanically reducing and reacting the groups of transition metals to form a ductile superconducting alloy in at least one interface within each group of metals, said superconducting alloy being superconducting at said high field, limiting the extent of the reaction so as to maintain zones of pure or nearly pure transition metal which are not superconducting at said high field in at least one of each said group of nearly pure transition metals, the mechanical reduction of the composite structure being sufficiently great that each superconducting interface zone and each non-superconducting zone is less than 100 nm (1000 Angstroms) thick, whereby each said non-superconducting zone serves as an artificial pinning center for each adjacent superconducting zone.

2. The method of claim 1 wherein the mechanical reduction is accomplished under pressure, temperature and time conditions to create a superconducting diffusion zone at each said interface which is about half as thick as each said transition metal layer.

3. The method of claim 1 wherein the mechanical reduction is accomplished under pressure, temperature and time conditions to create a superconducting diffusion zone at each said interface which is about half as thick as each said transition metal layer so that each diffusion zone is separated from the nearest adjacent diffusion zone by a thickness of undiffused transition metal about equal to the thickness of the diffusion zone.

4. The method of claim 1 which includes the steps of mechanically reducing the thickness of said layers sufficiently so that each diffusion zone is less than about 50 nm (500 Angstroms) thick and each undiffused zone is about equal in thickness to the diffusion zone.

5. The method of claim 1 wherein said metal bodies comprise a plurality of alternate layers of different transition metals.

6. The method of claim 1 wherein said metal bodies comprise a mixture of powders of at least two transition metals.

7. The method of claim 1 wherein said metal bodies comprise a mixture of short filaments of at least two transition metals having a length to diameter ratio of less than 10.

8. The method of claim 1 wherein said metal bodies comprise a plurality of filaments comprising a core of one transition metal surrounded by another transition metal.

9. The method of claim 1 wherein, alternate bodies are formed of different transition metals to form triplets, reacting the transition metals to form a ductile superconducting ternary alloy at the interfaces of these triplets of metals, limiting the extent of the reaction so as to maintain areas of pure or nearly pure transition metal along with the superconducting ternary alloy in at least one of each said triplet of transition metals, mechanically reducing the composite structure sufficiently that each pure or nearly pure transition metal zone serves as an artificial pinning site for each adjacent superconducting zone.

10. The method of claim 9 wherein, each pure or nearly pure transition metal body is less than 100 nm (1000 Angstroms) thick.

11. The method of claim 9 wherein the three transition metals are Nb, Ta and Ti, the tantalum layer being positioned between the Nb and Ti layers and being less than half as thick as each of the other two layers.

12. The method of claim 9 wherein the three transition metals are Nb,Ta and Ti, the Ti being positioned between the Nb and Ta.

13. The method of claim 12 wherein an additional layer of Ti is on the second side of the Ta layer.

## Patentansprüche

1. Verfahren zur Herstellung eines Supraleiters, der in einem starken Magnetfeld supraleitend ist, bei dem eine Mehrzahl von Metallkörpern in Verbundform eingesetzt wird, die aus den Übergangsmetallen Niob, Tantal, Titan, Zirkonium, Hafnium, Vanadium und deren Legierungen, die in dem starken Feld nicht supraleitend sind, ausgewählt werden, wobei abwechselnde Körper aus unterschiedlichen Übergangsmetallen unter Bildung von Gruppen aus mindestens zwei verschiedenen Metallen, die an ihren Grenzflächen in Kontakt miteinander stehen, gebildet werden, bei dem die Gruppen von Übergangsmetallen mechanisch reduziert und unter Bildung einer verformbaren supraleitenden Legierung an mindestens einer Grenzfläche innerhalb jeder Gruppe von Metallen umgesetzt werden, wobei die supraleitende Legierung in dem starken Feld supraleitend ist, bei dem ferner das Ausmaß der Umsetzung so begrenzt wird, daß Bereiche reinen oder nahezu reinen Übergangsmetalls, die in dem starken Feld nicht supraleitend sind, in mindestens einem Metall jeder dieser Gruppen nahezu reiner Übergangsmetalle erhalten bleiben, wobei die mechanische Reduzierung der Verbundstruktur ausreichend stark ist, damit jeder supraleitende Grenzflächenbereich und jeder nicht-supraleitende Bereich weniger als 100 nm (1000 Angström) dick ist, wodurch jeder nicht-supraleitende Bereich als künstliches Pinningzentrum für jeden benachbarten supraleitenden Bereich dient.

2. Verfahren nach Anspruch 1, bei dem die mechanische Reduzierung unter Druck-, Temperatur- und Zeitbedingungen erfolgt, die eine supraleitende Diffusionszone an jeder Grenzfläche erzeugen, die etwa halb so dick wie jede Übergangsmetallschicht ist.

3. Verfahren nach Anspruch 1, bei dem die mechanische Reduzierung unter Druck-, Temperatur- und Zeitbedingungen erfolgt, die eine supraleitende Diffusionszone an jeder Grenzfläche erzeugen, die etwa halb so dick wie jede Übergangsmetallschicht ist, so daß jede Diffusionszone von der nächstliegenden benachbarten Diffusionszone durch nicht diffundiertes Übergangsmetall von einer Dicke getrennt ist, die etwa gleich der Dicke der Diffusionszone ist.

4. Verfahren nach Anspruch 1, bei dem die Dicke der Schichten in ausreichendem Maße mechanisch reduziert wird, so daß jede Diffusionszone weniger als etwa 50 nm (500 Angström) dick ist und jede nicht diffundierte Zone eine Dicke besitzt, die etwa gleich der Dicke der Diffusionszone ist.

5. Verfahren nach Anspruch 1, bei dem die Metallkörper eine Mehrzahl von abwechselnden Schichten unterschiedlicher Übergangsmetalle umfassen.

6. Verfahren nach Anspruch 1, bei dem die Metallkörper ein Pulvergemisch aus mindestens zwei Übergangsmetallen umfassen.

7. Verfahren nach Anspruch 1, bei dem die Metallkörper ein Gemisch aus kurzen Filamenten mindestens zweier Übergangsmetalle mit einem Verhältnis von Länge zu Durchmesser von weniger als 10 umfassen.

8. Verfahren nach Anspruch 1, bei dem die Metallkörper eine Mehrzahl von Filamenten umfassen, die einen Kern aus einem Übergangsmetall aufweisen, der von einem anderen Übergangsmetall umgeben ist.

9. Verfahren nach Anspruch 1, bei dem abwechselnde Körper aus unterschiedlichen Übergangsmetallen unter Bildung von Triplets gebildet werden, die Übergangsmetalle unter Bildung einer verformbaren supraleitenden ternären Legierung an den Grenzflächen dieser Metalltriplets umgesetzt werden, das Ausmaß der Umsetzung so begrenzt wird, daß Bereiche reinen oder nahezu reinen Übergangsmetalls zusammen mit der supraleitenden ternären Legierung in mindestens einem Metall jedes dieser Übergangsmetalltriplets beibehalten werden, und bei dem die Verbundstruktur in ausreichendem Maße mechanisch reduziert wird, so daß jeder Bereich aus reinem oder nahezu reinem Übergangsmetall als künstliche Pinningstelle für jeden benachbarten supraleitenden Bereich dient.

10. Verfahren nach Anspruch 9, bei dem jeder Körper aus reinem oder nahezu reinem Übergangsmetall weniger als 100 nm (1000 Angström) dick ist.

11. Verfahren nach Anspruch 9, bei dem die drei Übergangsmetalle Nb, Ta und Ti sind, wobei sich die Tantalschicht zwischen den Nb- und Ti-Schichten befindet und weniger als halb so dick ist wie jede der anderen beiden Schichten.

12. Verfahren nach Anspruch 9, bei dem die drei Übergangsmetalle Nb, Ta und Ti sind, wobei sich das Ti zwischen Nb und Ta befindet.

13. Verfahren nach Anspruch 12, bei dem sich eine zusätzliche Ti-Schicht auf der zweiten Seite der Ta-Schicht befindet.

## Revendications

1. Procédé de fabrication d'un supraconducteur qui est supraconducteur à un champ magnétique élevé, comprenant les étapes de fourniture d'une pluralité de corps métalliques sous la forme d'une structure composite, lesdits corps métalliques étant choisis parmi les métaux de transition que sont le niobium, le tantale, le titane, le zirconium, l'hafnium ou le vanadium et des alliages de ceux-ci, qui ne sont pas supraconducteurs audit champ élevé, des corps alternés étant formés en métaux de transition différents pour former des groupes d'au moins deux métaux différents en contact interfacial, de réduction mécanique et de réaction des groupes de métaux de transition pour former un alliage supraconducteur ductile dans au moins une interface dans chaque groupe de métaux, ledit alliage supraconducteur étant supraconducteur audit champ élevé, de limitation de l'étendue de la réaction de manière à maintenir des zones de métal de transition pur ou pratiquement pur qui ne sont pas supraconductrices audit champ élevé dans au moins l'un de chaque dit groupe de métaux de transition pratiquement purs, la réduction mécanique de la structure composite étant suffisamment importante pour que chaque zone d'interface supraconductrice et que chaque zone non supraconductrice présentent une épaisseur inférieure à 100 nm (1000 angströms) et ainsi, chaque dite zone non supraconductrice joue le rôle de centre de pinning artificiel pour chaque zone supraconductrice adjacente.

2. Procédé selon la revendication 1, dans lequel la réduction mécanique est réalisée dans des conditions de pression, de température et de temps pour créer une zone de diffusion supraconductrice au niveau de chaque dite interface qui présente environ la moitié de l'épaisseur de chaque dite couche de métal de transition.

3. Procédé selon la revendication 1, dans lequel la réduction mécanique est réalisée dans des conditions de pression, de température et de temps pour créer une zone de diffusion supraconductrice au niveau de chaque dite interface qui présente une épaisseur égale à environ la moitié de celle de chaque dite couche de métal de transition de telle sorte que chaque zone de diffusion soit séparée de la zone de diffusion adjacente la plus proche d'une épaisseur d'un métal de transition non diffusé environ égale à l'épaisseur de la zone de diffusion.

4. Procédé selon la revendication 1, lequel inclut les étapes de réduction mécanique de l'épaisseur desdites couches suffisamment de telle sorte que chaque zone de diffusion présente une épaisseur inférieure à environ 50 nm (500 angströms) et que chaque zone non diffusée présente une épaisseur environ égale à celle de la zone de diffusion.

5. Procédé selon la revendication 1, dans lequel lesdits corps métalliques comprennent une pluralité de couches alternées de différents métaux de transition.

6. Procédé selon la revendication 1, dans lequel lesdits corps métalliques comprennent un mélange de poudres d'au moins deux métaux de transition.

7. Procédé selon la revendication 1, dans lequel lesdits corps métalliques comprennent un mélange de filaments courts d'au moins deux métaux de transition présentant un rapport longueur sur diamètre inférieur à 10.

8. Procédé selon la revendication 1, dans lequel lesdits corps métalliques comprennent une pluralité de filaments comprenant une âme en un métal de transition entourée par un autre métal de transition.

9. Procédé selon la revendication 1, dans lequel des corps alternés sont formés en différents métaux de transition pour former des triplets, en faisant réagir les métaux de transition pour former un alliage ternaire supraconducteur ductile au niveau des interfaces de ces triplets de métaux, en limitant l'étendue de la réaction de manière à maintenir des zones de métal de transition pur ou pratiquement pur en association avec l'alliage ternaire supraconducteur dans au moins l'un de chaque dit triplet de métaux de transition, en réduisant mécaniquement la structure composite suffisamment de telle sorte que chaque zone de métal de transition pur ou pratiquement pur joue le rôle de site de pinning artificiel pour chaque zone supraconductrice adjacente.

10. Procédé selon la revendication 9, dans lequel chaque corps de métal de transition pur ou pratiquement pur présente une épaisseur inférieure à 100 nm (1000 angströms).

11. Procédé selon la revendication 9, dans lequel les trois métaux de transition sont Nb, Ta et Ti, la couche de tantale étant positionnée entre les couches de Nb et de Ti et présentant une épaisseur inférieure à la moitié de celle de chacune des deux autres couches.

12. Procédé selon la revendication 9, dans lequel les trois métaux de transition sont Nb, Ta et Ti, le Ti étant positionné entre le Nb et le Ta.

13. Procédé selon la revendication 12, dans lequel une couche supplémentaire de Ti est sur le second côté de la couche de Ta.
